# EUROPÄISCHE PATENTANMELDUNG

(11) **EP 1 024 535 A2**
(43) Veröffentlichungstag der Anmeldung: **02.08.2000**
(21) Anmeldenummer: 00200227.7
(22) Anmeldetag: 20.01.2000
(51) Int. Cl.: H01L 27/01, H05K 3/40

(54) **Dünnschichtschaltkreis mit Bauteil**

(30) Priorität: 29.01.1999 DE 19903500
(71) Anmelder: Philips Corporate Intellectual Property GmbH, 52064 Aachen (DE); Koninklijke Philips Electronics N.V., 5621 BA Eindhoven (NL)
(72) Erfinder: Klee, Mareike, 52064 Aachen (DE); Brand, Hans-Woflgang, 52064 Aachen (DE); Mackens, Uwe, 52064 Aachen (DE); Kiewitt, Rainer, 52064 Aachen (DE); Fleuster, Martin, 52064 Aachen (DE); Nellisen, Antonius Johannes Maria, 52064 Aachen (DE); Baggerman, Antal Frans Jozef, 52064 Aachen (DE); de Samber, marc, 52064 Aachen (DE)
(74) Vertreter: Volmer, Georg, Dipl.-Ing.

(57) **Zusammenfassung**

Die Erfindung beschreibt einen Dünnschichtschaltkreis mit Bauteil. Der Dünnschichtschalkreis enthält ein Netzwerk aus Kondensatoren oder ein Netzwerk aus Kondensatoren und Widerständen oder ein Netzwerk aus Kondensatoren, Widerständen und Induktoren oder ein Netzwerk aus Kondensatoren und Induktoren. Durch Stromzuführungen (7) wie zum Beispiel SMD-Endkonrakte oder Bump-end-Kontakte auf kann der Dünnschichtschaltkreis mit Bauteil mit weiteren Bauelementen eines Schaltkreises verbunden werden bzw. durch Verwendung von Kontaktflächen mit aktiven Bauelementen kombiniert werden.

## Beschreibung

Die Erfindung betrifft einen Dünnschichtschalkreis mit Bauteil mit wenigstens einer ersten und zweiten Stromzuführung,
sowie mit einem Trägersubstrat,
wenigstens einer ersten strukturierten elektrisch leitenden Schicht,
darüberliegend wenigstens einem strukturierten Dielektrikum und
darüberliegend wenigstens einer zweiten strukturierten elektrisch leitenden Schicht sowie ein solches Bauteil.

Die Entwicklung zahlreicher elektronischer Geräte ist durch folgende Trends geprägt: Miniaturisierung, höhere Zuverlässigkeit, niedrigere oder zumindest konstante Preise bei zunehmender Funktionalität. Trotz aller Digitalisierungsmaßnahmen macht die Anzahl der passiven Bauelemente erfahrungsgemäß in zahlreichen Geräten der Konsumelektronik, beispielsweise in Fernsehgeräten oder Videorecordern, 70 % der vorhandenen Bauelemente aus.

Ein Schritt auf dem Weg zur steten Miniaturisierung stellt die sogenannte SMD-Technik dar. Die Grundlage für diese Technik bilden miniaturisierte Bauelemente (SMDs = Surface Mounted Devices), die direkt auf die Oberfläche von Leiterplatten oder Keramiksubstraten montiert werden. SMDs sind wesentlich Meiner als entsprechende herkömmlich bedrahtete Bauelemente. Bei konsequenter Ausnutzung können der Flächen- bzw. Raumbedarf und das Gewicht von Schaltungen halbiert bis gedrittelt werden. Auch kann durch optimalen Einsatz der SMD-Technik eine Kosteneinsparung erwirkt werden, da kleinere Leiterplatten verwendet werden können.

Durch weitere Miniaturisierung wird aber auch die Produktion, Handhabung und Montage von passiven SMD-Bauelementen immer schwieriger. Dies kann umgangen werden, indem integrierte passive Bauelemente (IPCs) zum Einsatz kommen. Bei dieser Technik werden passive Bauelemente, wie zum Beispiel Widerstände (R), Kondensatoren (C) oder Induktoren (L) zu untrennbaren Grundschaltungen und Systemen kombiniert. Durch Anwendung von Dünnschichttechniken erhält man mit Hilfe von Masken auf Trägerplatten aus einem isolierenden Material sogenannte Dünnschichtschaltkreise, die einer sehr stark verkleinerten gedruckten Schaltung entsprechen. Die Herstellung von Dünnschichtschaltkreisen ist bekannt und erfolgt im allgemeinen durch verschiedene aufeinanderfolgende oder gleichzeitig ablaufende Beschichtungsprozesse. Um einen Dünnschichtschaltkreis, der aus einer Kombination von Widerständen, Kondensatoren oder Induktoren besteht, zu realisieren, sind verschiedene Schichten mit unterschiedlichen Formgebungen, Zusammensetzungen und Dicken aufzubringen.

Eine einfache Realisierung von Schaltungen mit unterschiedlichsten passiven wie aktiven Bauelementen gelingt durch Kombination von diskreten (SMD-)Bauelementen mit aktiven Bauelementen, die eine spezielle Funktion (zum Beispiel eine Filterfunktion) besitzen. Ein Nachteil ist aber, daß SMD-Bauelemente alle einzeln aufgelötet werden müssen. Durch die Lötstellen werden große Flächen benötigt, wodurch die Schaltungen sehr groß werden.

Der Erfindung liegt die Aufgabe zugrunde, elektrische Schaltungen aus passiven Bauelementen oder aus passiven und aktiven Bauelementen weiter zu verkleinern.

Dieses Aufgabe wird gelöst durch einen Dünnschichtschaltkreis mit Bauteil mit wenigstens einer ersten und zweiten Stromzuführung,
sowie mit einem Trägersubstrat,
wenigstens einer ersten strukturierten elektrisch leitenden Schicht,
darüberliegend wenigstens einem strukturierten Dielektrikum und
darüberliegend wenigstens einer zweiten strukturierten elektrisch leitenden Schicht
   dadurch gekennzeichnet,
daß die Stromzuführung ein galvanischer SMD-Endkontakt oder ein Bump-end-Kontakt oder eine Konraktfläche ist.

An den Stromzuführungen, welche meist an gegenüberliegenden Seiten des Bauteiles angebracht sind, kann jedes erfindungsgemäße Bauteil mir weiteren Bauelementen eines Schalrkreises elektrisch verbunden werden. Je nach Art der Applikation oder Art der Bauteilmontage kann als Stromzuführung ein galvanischer SMD-Endkontakt oder ein Bump-end-Kontakt oder eine Kontaktfläche eingesetzt werden. Durch die Verwendung von SMD-Endkontakten beispielsweise aus Cr/Cu, Ni/Sn oder Cr/Cu, Cu/Ni/Sn oder Cr/Ni, Pb/Sn oder Bump-end-Konrakten können diskrete Bauteile hergestellt werden. Diese müssen dann nur noch auf der mit Leiterbahnen versehenen Leiterplatte befestigt werden. Der Einsatz von Kontaktflächen ermöglicht die Integration des Bauteiles mit aktiven Bauelementen.

In einer bevorzugten Ausführungsform ist zwischen dem strukturierten Dielektrikum und der zweiten strukturierten elektrisch leitenden Schicht eine strukturierte Barriereschicht aufgebracht.

Das erfindungsgemäße Bauteil weist je nach Strukturierung der einzelnen Schichten mindestens einen Kondensator mit zwei elektrisch leitenden Schichten (Elektroden) und einem Dielektrikum auf Um Reaktionen zwischen dem strukturierten Dielektrikum und der zweiten strukturierten elektrisch leitenden Schicht zu verhindern, kann zwischen dem strukturierten Dielektrikum und der zweiten strukturierten elektrisch leitenden Schicht eine strukturierte Barriereschicht aufgebracht sein.

In einer vorteilhaften Ausführung ist über der zweiten strukturierten elektrisch leitenden Schicht eine dritte strukturierte elektrisch leitende Schicht aus Cu, Au, Al, Al dotiert mit Cu, Al datiert mit Si oder Al dotiert mit Mg aufgebracht. Nach Abscheidung der Materialien wird die dritte elektrisch leitende Schicht beispielsweise mittels lithographischer Prozesse kombiniert mit Trocken- oder Naßätzverfahren so strukturiert, daß sie als Dünnschichtspule wirkt.

In dieser Ausführung des erfindungsgemäßen Bauteiles enthält das Bauteil je nach Strukturierung der einzelnen Schichten mindestens einen Kondensator und mindestens einen Induktor.

In einer weiteren vorteilhaften Ausführung ist zwischen dem strukturierten Dielektrikum und der zweiten strukturierten elektrisch leitenden Schicht eine strukturierte Widerstandsschicht aufgebracht.

Es kann eine anden vorteilhafte Ausführung sein, daß zwischen Trägersubstrat und erster strukturierter elektrisch leitender Schicht eine strukturierte Widerstandsschicht aufgebracht ist.

In beiden Ausführungen des erfindungsgemäßen Bauteiles enthält das Bauteil je nach Strukturierung der einzelnen Schichten mindestens einen Kondensator und mindestens einen Widerstand.

In einer bevorzugten Ausführungsform dieses erfindungsgemäßen Bauteiles ist über der zweiten strukturierten elektrisch leitenden Schicht eine dritte strukturierte elektrisch leitende Schicht aus Cu, Au, Al, Al dotiert mit Cu, Al dotiert mit Si oder Al dotiert mit Mg aufgebracht.

In dieser Ausführungsform enthält das Bauteil je nach Strukturierung der einzelnen Schichten aus mindestens einen Kondensator, mindestens einen Widerstand und mindestens einen Induktor.

In erfindungsgemäßen Bauteilen mit mindestens einem Induktor kann es bevorzugt sein, daß zwischen der zweiten strukturierten elektrisch leitenden Schicht und der dritten strukturierten elektrisch leitenden Schicht eine Keimschicht aus Ti, Cr, TiₓW_{y} (0 ≤ x ≤ 1, 0 ≤ y ≤ 1), , TiₓW_{y} (0 ≤ x ≤ 1, 0 ≤ y ≤ 1)/Au, Cr/Cu, NiₓCr_{y} (0 ≤ x ≤ 1, 0 ≤ y ≤ 1)/Au oder TiₓW_{y} (0 ≤ x ≤ 1, 0 ≤ y ≤ 1)/Cr/Cu aufgebracht ist.

Es ist bei allen erfindungsgernäßen Bauteilen bevorzugt, daß als Trägersubstrat ein keramisches Material, ein glaskeramisches Material, ein Glasmaterial oder ein keramisches Material mit einer Planarisierungsschicht aus Glas verwendet wird. Ein Trägersubstrat aus diesen Materialien ist kostengünstig herzustellen und die Prozeßkosten für diese Komponente können niedrig gehalten werden.

Es ist weiterhin bevorzugt, daß die ersten und zweiten strukturierten elektrisch leitenden Schichten aus einem Material mir einem Metall oder einer Legierung oder einem leitenden Oxid oder einem Metall und einer Legierung oder einem Metall und einem leitenden Oxid oder einem Metall, einer Legierung und einem leitenden Oxid sind. Nach dem Abscheiden der Materialien werden die erste und zweite elektrisch leitende Schicht beispielsweise mittels lithographischer Prozesse verbunden mit Naß- und Trockenärzschritten, entsprechend der Funktion, die der Dünnschichtschaltkreis erfüllen soll, strukturiert.

Es ist auch bevorzugt, daß das Dielektrikum ein Material mit einer relativen Dielektrizitätskonstanten von εᵣ > 3 enthält. Diese Materialien ermöglichen hohe Kapazitätswerte auf kleinen Abmessungen.

Es kann bevorzugt sein, daß zwischen Trägersubstrat und erster strukturierter elektrisch leitender Schicht eine Haftschicht aus Ti, Cr oder NiₓCr_{y} (0 ≤ x ≤ 1, 0 ≤ y ≤ 1) aufgebracht ist. Diese Hsftschicht verbessert die Haftung zwischen dem Trägersubstrat und der ersten elektrisch leitenden Schicht.

Es kann auch bevorzugt sein, daß zwischen der ersten strukturierten elektrisch leitenden Schicht und dem strukturierten Dielektrikum eine strukturierte Barriereschicht aufgebracht ist.

Diese Barriereschicht verhindert Reaktionen zwischen der ersten strukturierten elektrisch leitenden Schicht und dem strukturierten Dielektrikum.

Es ist auch bevorzugt, daß über dem gesamten Dünnschichtschaltkreis eine Schutzschicht aus einem anorganischen Material und/oder einem organischen Material aufgebracht ist.

Durch die Schutzschicht werden die darunterliegenden Schichten vor mechanischer Beanspruchung und Korrosion durch Feuchtigkeit geschützt.

Es kann auch bevorzugt sein, daß auf dem Trägersubstrat eine Antireaktionsschicht aufgebracht ist. Durch eine Antireaktionsschicht können Reaktionen mit dem Dielektrikum sowie rauhe Oberflächen der elektrisch leitenden Schichten, die zu Kurzschlüssen der Kondensatoren oder schlechten Hochfrequenzeigenschaften führen, vermieden werden.

Desweiteren betrifft die Erfindung auch ein Bauteil für einen Dünnschichtschaltkreis mit wenigstens einer ersten und zweiten Stromzuführung,
sowie mir einem Trägersubstrat,
wenigstens einer ersten strukturierten elektrisch leitenden Schicht,
darüberliegend wenigstens einem strukturierten Dielektrikum und
darüberliegenden wenigstens einer zweiten strukturierten elektrisch leitenden Schicht,
   dadurch gekennzeichnet,
daß die Stromzuführung ein galvanischer SMD-Endkontakt oder ein Bump-end-Kontakt oder eine Kontaktfläche ist.

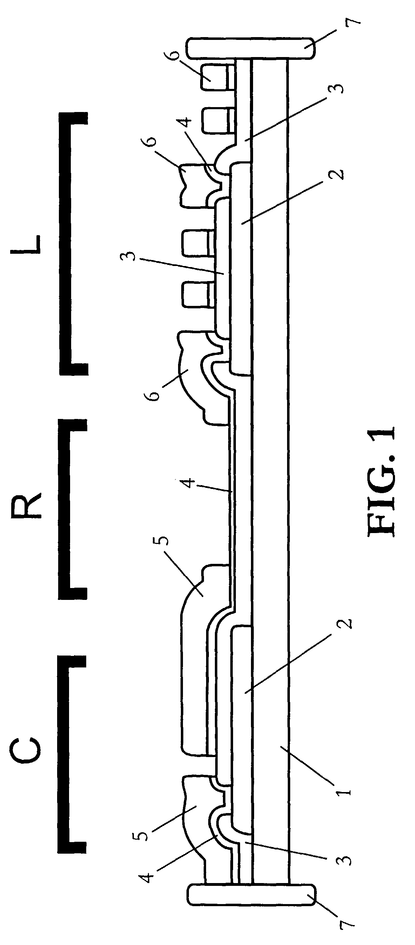

Im folgenden soll die Erfindung anhand einer Figur und anhand von fünf Ausführungsbeispielen erläutert werden. Dabei zeigt Fig. 1 im Querschnitt den schematischen Aufbau eines erfindungsgemäßen Dünnschichtschaltkreises mir Bauteil, welcher einen Kondensator, einen Widerstand und einen Induktor aufweist.

Gemäß Fig. 1 weist ein Dünnschichtschaltkreis mir Bauteil ein Trägersubstrat 1 auf, welches beispielsweise ein keramisches Material, ein glaskeramisches Material, ein Glasmaterial oder keramisches Material mit einer Planarisierungsschicht aus Glas enthält. Auf dieses Trägersubstrat 1 wurde eine erste elektrisch leitende Schicht 2, welche die untere Elektrode für die Kondensatoren, die erste leitende Schicht für die Verbindungsleitungen und die Verbindungen für die Induktoren darstellt, aufgebracht und strukturiert. Im nächsten Schritt wurde ein Dielektrikum 3 aus einem Material mit einer relativen Dielektrizitätskonstanten von εᵣ> 3 abgeschieden. Im allgemeinen bedeckt diese Schicht die ganze Fläche des Trägersubstrats 1 und wird nur an bestimmten Stellen unterbrochen, um Kontaktlöcher zu der darunterliegenden ersten strukturierten elektrisch leitenden Schicht 2 herzustellen. Das Dielektrikum 3 kann beispielsweise Si₃N₄, SiO₂, SiₓN_{y}O_{z} (0 ≤ x ≤1, 0 ≤ y ≤ 1, 0 ≤ z ≤ 1), Al₂O₃, Ta₂O₅, (Ta₂O₅)ₓ-(Al₂O₃)ₗ₋ₓ (0 ≤ x ≤ 1), (Ta₂O₅)ₓ-(TiO₂)ₗ₋ₓ (0 ≤ x ≤ 1), (Ta₂O₅)ₓ-(Nb₂O₅)ₗ₋ₓ (0 ≤ x ≤ 1), (Ta₂O₅)ₓ-(SiO₂)ₗ₋ₓ (0 ≤ x ≤ 1), TiO₂, PbZrₓTiₗ₋ₓ O₃ (0 ≤ x ≤ 1) mit und ohne Bleiüberschuß, Pb_{l-αy}La_{y}ZrₓTiₗ₋ₓO₃ (0 ≤ x ≤ 1, 0 ≤ y ≤ 0.2, 1.3 ≤ α ≤ 1.5), Pb_{l-αx}LaₓTiO₃ (0 ≤ x ≤ 0.3, 1.3 ≤ α ≤ 1.5), (Pb,Ca)TiO₃, BaTiO₃, BaTiO₃ mit Ce-Dotierung, BaTiO₃ mit Nb- und/oder Co-Dotierung, BaZrₓTiₗ₋ₓO₃ (0 ≤ x ≤ 1), Baₗ₋ₓPbₓO₃ (0 ≤ x ≤ 1), Ba_{l-y}Sr_{y}ZrₓTiₗ₋ₓO₃, (0 ≤ x ≤ 1, 0 ≤ y ≤ 1), Baₗ₋ₓSrₓTiO₃ (0 ≤ x ≤ 1), SrTiO₃ mit Dotierungen von zum Beispiel La, Nb, Fe oder Mn, SrZrₓTiₗ₋ₓO₃ (x = 0 bis 1) mit und ohne
La-Dotierung, CaOₓZnO_{y}(Nb₂O₅)_{z} (x = 0.01 bis 0.05 y = 0.43 bis 0.55,
z = 0.44 bis 0.52), (BaTiO₃)_{0.18 bis 0.27} + (Nd₂O₃)_{0.316 bis 0.355} + (TiO₂)_{0.276 bis 0.355} + (Bi₂O₃)_{0.025 bis 0.081} + x ZnO, CaTiO₃ + CaTiSiO₅, (Sr,Ca)(Ti,Zr)O_{3,} (Sr,Ca,M)(Ti,Zr)O₃ (M = Mg oder Zn), (Sr,Ca,Mg,Zn)Ti,Zr,Si)O₃, (Sr,Ca,Cu,Mn,Pb)TiO₃ + BiO₃, BaO-TiO₂-Nd₂O₃-Nb₂O₅, (Bi₂O₃)ₓ(Nb₂O₅)ₗ₋ₓ und Zugaben von SiO₂, MnO₂ oder PbO, BaTiO₃ mit Nb₂O₅, CoO, CeO₂, ZnO und Oxide des Mangans als Dotierungen, BaTiO₃ + CaZrO₃, Zugaben von MnO₂, MgO und Seltenerdoxiden, (Ba,Ca)TiO₃ + Nb₂O₅, Co₂O₃, MnO₂, Zr(Ti,Sn)O₄, BaO-PbO-Nd₂O₃-TiO₂, Ba(Zn,Ta)O₃, BaZrO₃, Ba₂Ti₉O₂₀, Ba₂Ti₉₋ₓZrₓO₂₀ (0 ≤ x ≤ 1) mit und ohne Mn-Dotierungen, BaTi₅O₁₁, BaTi₄O₉, CaₓSm_{y}Ti_{z}Oₙ (0 ≤ x ≤ 1, 0.5 ≤ y ≤ 1, 0 ≤ z ≤ 1, 0 ≤ n ≤ 1),
[Bi₃(Ni₂Nb)O₉]ₗ₋ₓ-(Bi₂(ZnNb_{2(l+d)y}O_{3+6y+5yd})ₓ (0 ≤ x ≤ 1, 0.5 ≤ y ≤ 1.5, -0.05 ≤ d ≤ 0.05), CaZrO₃, Nd₂Ti₂O₇, PbNb_{4/5x}((Zr_{0.6}Sn_{0.4})_{l-y}Ti_{y}))ₗ₋ₓO₃ (0 ≤ x ≤ 0.9, 0 ≤ y ≤ 1),
[Pb(Mg_{1/3}Nb_{2/3)}O₃]ₓ-(PbTiO₃)ₗ₋ₓ (0 ≤ x ≤ 1), (Pb,Ba,Sr) (Mg_{1/3}Nb_{2/3})ₓTi_{y}(Zn_{1/3}Nb_{2/3})_{l-x-y}O₃ (0 ≤ x ≤ 1, 0 ≤ y ≤ 1, x+y ≤ 1),
i) Pb(Mg_{0.5}W_{0.5})O₃
ii) Pb(Fe_{0.5}Nb_{0.5})O₃
iii) Pb(Fe_{2/3}W_{1/3})O₃
iv) Pb(Ni_{1/3}Nb_{2/3})O₃
v) Pb(Zn_{1/3}Nb_{2/3})O₃
vi) Pb(Sc_{0.5}Ta_{0.5})O₃
sowie Kombinationen der Verbindungen i) bis vi) mit PbTiO₃ und/oder Pb(Mg_{1/3}Nb_{2/3})O₃ mit und ohne Bleiüberschuß enthalten. Auf dem Dielektrikum 3 wurde eine Widersrandsschicht 4 abgeschieden und strukturiert. Diese strukturierte Widerstandsschicht 4 kann beispielsweise NiₓCr_{y} (0 ≤ x ≤ 1, 0 ≤ y ≤ 1), NiₓCr_{y}Al_{z} (0 ≤ x ≤ 1, 0 ≤ y ≤ 1, 0 ≤ z ≤ 1), TiₓW_{y}N_{z}(0 ≤ x ≤ 1, 0 ≤ y ≤ 1, 0 ≤ z ≤ 1), TaₓN_{y}( 0 ≤ x ≤ 1, 0 ≤ y ≤ 1), SiₓCr_{y}O_{z} (0 ≤ x ≤ 1, 0 ≤ y ≤ 1, 0 ≤ z ≤ 1), SiₓCr_{y}N_{z} (0 ≤ x ≤1, 0 ≤ y ≤ 1, 0 ≤ z ≤ 1), Polysilicium,TiₓW_{y} (0 ≤ x ≤ 1, 0 ≤ y ≤ 1) oder CuₓNi_{y} (0 ≤ x ≤ 1,0 ≤ y ≤ 1) enthalten. Im nächsten Schritt wurde eine zweite elektrisch leitende Schicht 5, welche die oberen Elektroden der Kondensatoren darstellt, abgeschieden und strukturiert. Die erste elektrisch leitende Schicht 2 sowie die zweite elektrisch leitende Schicht 5 können zum Beispiel Pt (50 nm bis 1 µm), Ti (10 bis 20 nm)/Pt (20 bis 600 nm), Ti (10 bis 20 nm)/Pt (20 bis 600 nm)/Ti (5 bis 20 nm), Al, Al dotiert mit einigen Prozent Cu, Al dotiert mit einigen Prozent Si, Al doriert mit einigen Prozent Mg, Ti/Pt/Al, Ti/Ag, Ti/Ag/Ti, W, Ni, Cu, Ti/Ag/Ir, Ti/Ir, Ti/Pd, Ti/Agₗ₋ₓPtₓ (0 ≤ x ≤ 1), Ti/Agₗ₋ₓPdₓ (0 ≤ x ≤ 1), Ti/Ptₗ₋ₓAlₓ (0 ≤ x ≤ 1), Ptₗ₋ₓAlₓ (0 ≤ x ≤ 1), Ti/Ag/Ptₗ₋ₓAlₓ (0 ≤ x ≤ 1), Ti/Ag/Ru, Ti/Ag/Ir/IrOₓ (0 ≤ x ≤ 2), Ti/Ag/Ru/RuOₓ (0 ≤ x ≤ 2), Ti/Ag/Ru/RuₓPtₗ₋ₓ (0 ≤ x ≤ 1),
Ti/Ag/Ru/RuₓPtₗ₋ₓ/RuO_{y} (0 ≤ x ≤ 1, 0 ≤ y ≤ 2), Ti/Ag/Ru/RuOₓ/Ru_{y}Pt_{l-y} (0 ≤ x ≤ 2, 0 ≤ y ≤ 1), Ti/Ag/RuₓPtₗ₋ₓ (0 ≤ x ≤ 1), Ti/Ag/PtₓAlₗ₋ₓ (0 ≤ x ≤ 1), PtₓAlₗ₋ₓ/Ag/Pt_{y}Al_{l-y} (0 ≤ x ≤ 1, 0 ≤ y ≤ 1),Ti/Ag/Pt_{y}(RhOₓ)_{l-y} (0 ≤ x ≤ 2, 0 ≤ y ≤ 1), Ti/Ag/Rh/RhOₓ (0 ≤ x ≤ 2), Ti/Ag/PtₓRhₗ₋ₓ (0 ≤ x ≤ 1), Ti/Ag/Pt_{y}(RhOₓ)_{l-y}/Pt_{z}Rh_{l-z} (0 ≤ x ≤ 2, 0 ≤ y ≤ 1, 0 ≤ z ≤ 1), Ti/AgₓPtₗ₋ₓ/Ir (0 ≤ x ≤ 1), Ti/AgₓPtₗ₋ₓ/Ir/IrO_{y} (0 ≤ x ≤ 1, 0 ≤ y ≤ 2),
Ti/AgₓPtₗ₋ₓ/Pt_{y}Al_{l-y} (0 ≤ x ≤ 1, 0 ≤ y ≤ 1), Ti/AgₓPtₗ₋ₓ/Ru (0 ≤ x ≤ 1), Ti/AgₓPtₗ₋ₓ/Ru/RuO_{y} (0 ≤ x ≤ 1, 0 ≤ y ≤ 2), Ti/Ag/Cr, Ti/Ag/Ti/ITO, Ti/Ag/Cr/ITO, Ti/Ag/ITO, Ti/Ni/ITO, Ti/Ni/Al/ITO, Ti/Ni oder Ti/Cu enthalten. Zur Bildung der Induktoren wurde eine dritte elektrisch leitende Schicht 6, welche beispielsweise Cu, Au, Al, Al doriert mit Cu, Al doriert mit Si oder Al datiert mit Mg enthält, auf der zweiten elektrisch leitenden Schicht 5 abgeschieden und strukturiert. Außerdem sind an gegenüberliegenden Seiten des Baureiles Stromzuführungen 7 befestigt. Als Stromführung 7 kann ein galvanischer SMD-Endkonrakt aus Cr/Cu, Ni/Sn oder Cr/Cu, CufNi/Sn oder Cr/Ni, Pb/Sn oder ein Bumpend-Kontakt oder eine Kontaktfläche eingesetzt werden.

Weiterhin kann auf dem Trägersubstrat 1 eine Antireaktionsschicht aus Glas, TiO₂, Al₂O₃ oder ZrO₂ abgeschieden werden.

Alternativ kann zwischen dem Trägersubstrat 1 bzw. gegebenenfalls der Antireaktionsschicht und erster elektrisch leitender Schicht 2 eine Haftschicht, welche beispielsweise Ti, Cr oder NiₓCr_{y} (0 ≤ x ≤ 1, 0 ≤ y ≤ 1) enthält, aufgebracht werden.

Außerdem kann eine Barriereschicht, welche zum Beispiel Ti, Cr, TiₓW_{y} (0 ≤ x ≤ 1, 0 ≤ y ≤ 1), IrₓO_{y} (0 ≤ x ≤1, 0 ≤ y ≤ 1), RuₓO_{y} (0 ≤ x ≤1, 0 ≤ 1, 0 ≤ y ≤ 1), TiₓCr_{y} (0 ≤ x ≤ 1, 0 ≤ y ≤ 1), PtₓRh_{y}O_{z} (0 ≤ x ≤ 1, 0 ≤ y ≤ 1, 0 ≤ z ≤ 1), PtₓAl_{y}(0 ≤ x ≤ 1, 0 ≤ y ≤ 1), NiₓCr_{y} (0 ≤ x ≤1, 0 ≤ y ≤ 1) oder ITO enthält, zwischen der ersten elektrisch leitenden Schicht 2 und dem Dielektrikum 3 aufgebracht werden. Bei einem Dünnschichtschaltkreis, der nur Kondensatoren enthält, kann alternativ auch zwischen dem Dielektrikum 3 und der zweiten elektrisch leitenden Schicht 5 eine Barriereschicht aufgebracht werden.

Die Widerstandsschicht, welche beispielsweise aus NiₓCr_{y} (0 ≤ x ≤ 1, 0 ≤ y ≤ 1), NiₓCr_{y}Al_{z} (0 ≤ x ≤1, 0 ≤ y ≤ 1, 0 ≤ z ≤ 1), TiₓW_{y}N_{z} (0 ≤ x ≤1, 0 ≤ y ≤ 1, 0 ≤ z ≤ 1), TaₓN_{y} ( 0 ≤ x ≤ 1, 0 ≤ y ≤ 1), SiₓCr_{y}O_{z} (0 ≤ x ≤1, 0 ≤ y ≤ 1, 0 ≤ z ≤ 1), SiₓCr_{y}N_{z} (0 ≤ x ≤ 1, 0 ≤ y ≤ 1, 0 ≤ z ≤ 1), Polysilicium,TiₓW_{y} (0 ≤ x ≤ 1, 0 ≤ y ≤ 1) oder CuₓNi_{y} (0 ≤ x ≤ 1, 0 ≤ y ≤ 1) enthält, kann alternativ auch zwischen dem Trägersubstrat 1 und der ersten strukturierten elektrisch leitenden Schicht 2 aufgebracht werden.

Außerdem kann zwischen der zweiten strukturierten elektrisch leitenden Schicht 5 und der dritten strukturierten elektrisch leitenden Schicht 6 eine Keimschicht aus beispielsweise Ti, Cr, TiₓW_{y} (0 ≤ x ≤1, 0 ≤ y ≤ 1), TiₓW_{y} (0 ≤ x ≤ 1, 0 ≤ y ≤ 1)/Au, Cr/Cu, NiₓCr_{y} (0 ≤ x ≤ 1, 0 ≤ y ≤ 1)/Au oder TiₓW_{y} (0 ≤ x ≤ 1, 0 ≤ y ≤ 1)/Cr/Cu aufgebracht werden.

Über dem gesamten Dünnschichtschaltkreis kann eine Schutzschicht aus einem anorganischen Material wie beispielsweise SiO₂ oder Si₃N₄ und/oder einem orgahischen Material wie zum Beispiel Polyimid oder Polybenzocyclobuten aufgebracht werden.

### Ausführungsbeispiel 1

Auf ein Trägersubstrat 1 aus Al₂O₃ mit einer Planarisierungsschicht aus Glas wurde eine erste elektrische leitende Schicht 2 aus Al datiert mit Cu abgeschieden und strukturiert. Im nächsten Schritt wurde über die gesamte Fläche des Trägersubstrates 1 ein Dielektrikum 3 aus Si₃N₄ abgeschieden und strukturiert. Auf dem Dielektrikum 3 befindet sich eine strukturierte Widerstandsschicht 4 aus Ni_{0.305}Cr_{0.57}Al_{0.125}. Auf einem Teil der Widerstandsschicht 4 wurde eine zweite elektrisch leitende Schicht 5 aus Al datiert mit Cu abgeschieden und strukturiert. Auf einem Teil der zweiten elektrisch leitenden Schicht 5 wurde eine dritte elektrisch leitende Schicht 6 aus Al datiert mit Cu abgeschieden und zu einer Dünnschichtspule strukturiert. Der gesamte Dünnschichtschaltkreis wurde mir einer Schutzschicht aus Si₃N₄ und Polyimid versehen. Außerdem sind an beiden Seiten des Bauteiles Cr/Cu, Cu/Ni/Sn SMD-Endkontakte als Stromzuführungen 7 befestigt.

### Ausführungsbeispiel 2

Auf ein Trägersubstrat 1 aus Glas wurde eine erste elektrische leitende Schicht 2 aus Al abgeschieden und strukturiert. Im nächsten Schritt wurde über die gesamte Fläche des Trägersubstrates 1 ein Dielektrikum 3 aus Si₃N₄ abgeschieden und strukturiert. Auf dem Dielektrikum 3 befindet sich eine strukturierte Widerstandsschicht 4 aus Ti_{0.14} W_{0.51}N_{0.35}. Auf der Widerstandsschicht 4 wurde zur Herstellung eines Dünnschichtkondensators eine zweite elektrisch leitende Schicht 5 aus Au abgeschieden und strukturiert. Eine dritte elektrisch leitende Schicht 6, welche Au enthält, wurde zusätzlich auf einem Bereich der zweiten elektrisch leitenden Schicht 5 abgeschieden und zu einer Dünnschichtspule strukturiert. Der Dünnschichtschaltkreis wurde mit einer Schutzschicht aus Si₃N₄ und Polyimid versehen. Außerdem sind an beiden Seiten des Bauteiles Cr/Cu, Cu/Ni/Sn SMD-Endkonrakte als Stromzuführungen 7 befestigt.

### Ausführungsbeispiel 3

Auf ein Trägersubstrat 1 aus Glas wurde eine Planarisierungsschicht aus TiO₂ aufgebracht und darauf wurde eine erste elektrische leitende Schicht 2 aus Ti/Pt abgeschieden und strukturiert. Im nächsten Schritt wurde über die gesamte Fläche des Trägersubstrates 1 ein Dielektrikum 3 aus PbZr_{0.53}Ti_{0.47}O₃ datiert mit 5 % Lanthan abgeschieden und strukturiert. Auf dem Dielektrikum 3 befindet sich eine strukturierte Widersrandsschicht 4 aus Ti_{0.14}W_{0.51}N_{0.35} Auf der Widerstandsschichr 4 wurde eine zweite elektrisch leitende Schicht 5 aus Al abgeschieden und strukturiert. Eine dritte elektrisch leitende Schicht 6, welche Al datiert mit Cu enthält, wurde auf einem Teil der zweiten elektrisch leitenden Schicht 5 abgeschieden und zu einer Dünnschichtspule strukturiert. Der Dünnschichtschaltkreis wird mit einer Schutzschicht aus Si₃N₄ und Polyimid versehen. Außerdem sind an beiden Seiten des Bauteiles Cr/Cu, Ni/Sn SMD-Endkontakte als Stromzuführungen 7 befestigt.

### Ausführungsbeispiel 4

Zur Realisierung eines T-Filters, das zum Beispiel aus sechzehn Widerständen und acht Kondensatoren besteht, wurde auf einem Trägersubstrat 1 aus Al₂O₃ mit einer Planarisierungsschicht aus Glas eine erste elektrisch leitende Schicht 2 aus Al datiert mit Cu abgeschieden und strukturiert. Im nächsten Schritt wurde über der gesamten Fläche des Trägersubstrats 1 ein Dielektrikum 3 aus Si₃N₄ abgeschieden und strukturiert. Auf dem Dielektrikum 3 befindet sich eine strukturierte Widerstandsschicht 4 aus Ni_{0.305}Cr_{0.57}Al_{0.125}. Auf der Widerstandsschicht 4 wurde eine zweite elektrisch leitende Schicht 5 aus Al datiert mit Cu abgeschieden und strukturiert. Der Dünnschichtschaltkreis wurde mir einer Schutzschicht aus Si₃N₄ und Polyimid versehen. Außerdem sind an beiden Seiten des Bauteiles Cr/Cu, Cu/Ni/Sn SMD-Endkontakte als Stromzuführungen 7 befestigt.

### Ausführungsbeispiel 5

Zur Realisierung eines T-Filters, das zum Beispiel aus sechzehn Widerständen und Kondensatoren besteht, wurde auf einem Trägersubstrat 1 aus Al₂O₃ mit einer Planarisierungsschicht aus Glas zunächst eine Antireaktionsschicht aus TiO₂ und anschließend eine erste elektrische Leitende Schicht 2 aus Ti/Pt abgeschieden und strukturiert. Im nächsten Schritt wurde über die gesamte Fläche des Trägersubstraces 1 ein Dielektrikum 3 aus PbZr_{0.53}Ti_{0.47}O₃ datiert mit 5 % Lanthan abgeschieden und strukturiert. Auf dem Dielektrikum befindet sich eine strukturierte Widerstandsschicht 4 aus Ti_{0.14}W_{0.51}N_{0.35}. Auf der Widerstandsschicht 4 wurde eine zweite elektrisch leitende Schicht 5 aus Al abgeschieden und strukturiert. Der Dünnschichtschaltkreis wurde mit einer Schutzschicht aus Si₃N₄ und Polymid versehen. Außerdem sind an beiden Seiten des Bauteiles Cr/Cu, Ni/Sn SMD-Endkontakte als Stromzuführungen 7 befestigt.

## Patentansprüche

1. Dünnschichtschaltkreis mit Bauteil mit wenigstens einer ersten und zweiten Stromzuführung (7),
sowie mit einem Trägersubstrat (1),
wenigstens einer ersten strukturierten elektrisch leitenden Schicht (2),
darüberliegend wenigstens einem strukturierten Dielektrikum (3) und
darüberliegenden wenigstens einer zweiten strukturierten elektrisch leitenden Schicht (5),
dadurch gekennzeichnet,
daß die Stromzuführung (7) ein galvanischen SMD-Endkontakt oder ein Bump-end-Kontakt oder eine Kontaktfläche ist.

2. Dünnschichtschaltkreis mit Bauteil nach Anspruch 1,
dadurch gekennzeichnet,
daß zwischen dem strukturierten Dielektrikum (3) und der zweiten strukturierten elektrisch leitenden Schicht (5) eine strukturierte Barriereschicht aufgebracht ist.

3. Dünnschichtschaltkreis mit Bauteil nach Anspruch 1 und 2,
dadurch gekennzeichnet,
daß über der zweiten strukturierten elektrisch leitenden Schicht (5) eine dritte strukturierte elektrisch leitende Schicht (6) aus Cu, Au, Al Al datiert mit Cu, Al dotiert mit Si oder Al dotiert mit Mg aufgebracht ist.

4. Dünnschichtschaltkreis mit Bauteil nach Anspruch 1,
dadurch gekennzeichnet,
daß zwischen dem strukturierten Dielektrikum (3) und der zweiten strukturierten elektrisch leitenden Schicht (5) eine strukturierte Widerstandsschicht (4) aufgebracht ist.

5. Dünnschichtschaltkreis mit Bauteil nach Anspruch 1 und 2,
dadurch gekennzeichnet,
daß zwischen dem Trägersubstrat (1) und erster strukturierter elektrisch leitender Schicht (2) eine strukturierte Widerstandsschicht aufgebracht ist.

6. Dünnschichtschaltkreis mit Bauteil nach Anspruch 4 und 5,
dadurch gekennzeichnet,
daß über der zweiten strukturierten elektrisch leitenden Schicht (5) eine strukturierte dritte elektrisch leitende Schicht (6) aus Cu, Au, Al, Al dotiert mit Cu, Al dotiert mit Si oder Al doriert mit Mg aufgebracht ist.

7. Dünnschichtschaltkreis mit Bauteil nach Anspruch 3 und 6,
dadurch gekennzeichnet,
daß zwischen der zweiten strukturierten elektrisch leitenden Schicht (5) und der dritten strukturierten elektrisch leitenden Schicht (6) eine Keimschicht aus Ti, Cr, TiₓW_{y} (0 ≤ x ≤ 1, 0 ≤ y ≤ 1), TiₓW_{y} (0 ≤ x ≤ 1, 0 ≤ y ≤ 1)/Au,Cr/Cu, NiₓCr_{y} (0 ≤ x ≤ 1, 0 ≤ y ≤ 1)/Au oder TiₓW_{y} (0 ≤ x ≤ 1, 0 ≤ y ≤ 1)/Cr/Cu aufgebracht ist.

8. Dünnschichtschaltkreis mit Bauteil nach Anspruch 1 bis 6,
dadurch gekennzeichnet,
daß das Trägersubstrat (1).ein keramisches Material, ein glaskeramisches Material, ein Glasmaterial oder keramisches Material mit einer Planarisierungsschicht aus Glas enthält.

9. Dünnschichtschallkreis mit Bauteil nach Anspruch 1 bis 6,
dadurch gekennzeichnet,
daß die strukturierten elektrisch leitenden Schichten (3, 5) aus einem Material mit einem Metall oder einer Legierung oder einem leitenden Oxid oder einem Metall und einer Legierung oder einem Metall und einem leitenden Oxid oder einem Metall, einer Legierung und einem leitenden Oxid sind.

10. Dünnschichtschaltkreis mit Bauteil nach Anspruch 1 bis 6,
dadurch gekennzeichnet,
daß das Dielektrikum (3) ein Material mit einer relativen Dielektrizitätskonsranten von εᵣ > 3 enthält.

11. Dünnschichtschaltkreis mit Bauteil nach Anspruch 1 bis 4 und 6,
dadurch gekennzeichnet,
daß zwischen Trägersubstrat (1) und erster strukturierter elektrisch leitender Schicht (2) eine strukturierte Haftschicht aus Ti, Cr oder NiₓCr_{y} (0 ≤ x ≤ 1, 0 ≤ y ≤ 1) aufgebracht ist

12. Dünnschichtschaltkreis mit Bauteil nach Anspruch 1 bis 6,
dadurch gekennzeichnet,
daß zwischen der ersten strukturierten elektrisch leitenden Schicht (2) und dem strukturierten Dielektrikum (3) eine strukturierte Barriereschicht aufgebracht ist.

13. Dünnschichtschaltkreis mit Bauteil nach Anspruch 1 bis 6,
dadurch gekennzeichnet,
daß über dem gesamten Dünnschichtschaltkreis eine Schutzschicht aus einem anorganischen Material und/oder einem organischen Material aufgebracht ist.

14. Dünnschichtschaltkreis mit Bauteil nach Anspruch 1 bis 6,
dadurch gekennzeichnet,
daß auf dem Trägersubstrat (1) eine Antireaktionsschicht aufgebracht ist.

15. Bauteil für einen Dünnschichtschaltkreis mit wenigstens einer ersten und zweiten Stromzuführung (7),
sowie mit einem Trägersubstrat (1),
wenigstens einer ersten strukturierten elektrisch leitenden Schicht (2),
darüberliegend wenigstens einem strukturierten Dielektrikum (3) und
darüberliegenden wenigstens einer zweiten strukturierten elektrisch leitenden Schicht (5),
dadurch gekennzeichnet,
daß die Stromzuführung (7) ein galvanischer SMD-Endkantakt oder ein Bump-end-Kontakt oder eine Kontaktfläche ist.
